# EUROPEAN PATENT APPLICATION

(11) **EP 2 400 570 A2**
(43) Date of publication of application: **28.12.2011**
(21) Application number: 09840487.4
(22) Date of filing: 29.12.2009
(51) Int. Cl.: H01L 33/64

(54) **SUBSTRATE FOR AN OPTICAL DEVICE, AN OPTICAL DEVICE PACKAGE COMPRISING THE SAME AND A PRODUCTION METHOD FOR THE SAME**

(30) Priority: 17.02.2009 KR 20090012728
(71) Applicant: Point Engineering Co., Ltd., Gyeonggi-do 445-861 (KR)
(72) Inventor: NAM, Ki Myung, Cheonan-si Chungcheongnam-do 330-849 (KR)
(74) Representative: Vossius & Partner
(86) International application number: PCT/KR2009/007852
(87) International publication number: WO 2010/095811

(57) **Abstract**

The present invention relates to a substrate for an optical device, to an optical device package comprising the same and to a production method for the same. According to the present invention, the substrate for an optical device, the optical device package comprising the same and the production method for the same may comprise: a metal substrate; a first anodized layer which is formed on the top surface of the metal substrate and insulates the metal substrate; and a first and a second electrode formed insulated from each other on the top of the first anodized layer.

## Description

### Technical Field

The present invention relates to a substrate for an optical device, an optical device package comprising the substrate, and a method of manufacturing the optical device package.

### Background Art

An optical device serves to convert electric energy into light or light energy into electric energy, and has various sizes and shapes depending on the intended use.

Recently, among optical devices, a light emitting diode (hereinafter, referred to as 'LED') has been generally used in the field of illumination, displays or the like. An LED is mounted on a printed circuit board, and is used in the form of a single device or an array. LEDs are advantageous in that they have high luminance and high energy efficiency, but are problematic in that they generate a large amount of heat.

In order to solve the above problem of heat generation, conventionally, a heat sink has been provided at the lower portion of an LED package, or metal pads for thermal conduction have been formed on a printed circuit board. However, when a heat sink is used, there is a problem in that the size of an LED package increases and in that additional processes must be performed. Further, even when metal pads are formed on a printed circuit board, there is a problem in that the heat emitted from LED cannot be efficiently discharged to the outside.

Meanwhile, optical devices as well as LEDs generally include a drive unit, and the drive unit emits heat. Therefore, in order to discharge the heat emitted from the drive unit to the outside, the above-mentioned heat sink or the like are used. However, even in this case, there is a problem in that the size of an optical device increases and the production cost thereof increases.

### Disclosure

### Technical Problem

An object of the present invention is to provide a substrate for an optical device, which has high thermal conductivity because an anodized layer without voids is formed on a metal substrate, an optical device package comprising the substrate, and a method of manufacturing the optical device package.

Another object of the present invention is to provide a substrate for an optical device, which can adjust the thickness of an anodized layer by performing an anodizing process one or more times, an optical device package comprising the substrate, and a method of manufacturing the optical device package.

Still another object of the present invention is to provide a substrate for an optical device, in which an electrode structure connected with an optical device is formed in the form of a metal layer disposed on an anodized layer, an optical device package comprising the substrate, and a method of manufacturing the optical device package.

Still another object of the present invention is to provide a substrate for an optical device, which can improve light use efficiency, an optical device package comprising the substrate, and a method of manufacturing the optical device package.

### Technical Solution

An aspect of the present invention provides a substrate for an optical device, including: a metal substrate; a first anodized layer formed on the metal substrate to insulate the metal substrate; and first and second electrodes formed on the first anodized layer such that the first and second electrodes are insulated from each other.

Another aspect of the present invention provides an optical device package, including: a substrate for an optical device including a metal substrate, a first anodized layer formed on the metal substrate and insulating the metal substrate, and first and second electrodes formed on the first anodized layer and insulated from each other; an optical device disposed between the first and second electrodes; a first wire connecting the optical device with the first electrode; and a second wire connecting the optical device with the second electrode.

Still another aspect of the present invention provides a method of manufacturing a substrate for an optical device, including the steps of: (a) forming a first anodized layer on a surface of a metal substrate to insulate the metal substrate; (b) forming a second anodized layer on the first anodized layer; (c) forming a first metal layer on the first anodized layer; (d) forming a second metal layer on the first metal layer; and (e) etching the first metal layer and the second metal layer to form first and second electrodes that face each other and are insulated from each other.

Still another aspect of the present invention provides a method of manufacturing a substrate for an optical device, including the steps of: (a) forming a first anodized layer on a surface of a metal substrate to insulate the metal substrate; (b) forming first and second electrodes on the first anodized layer, the fist and second electrodes including any one of first, second and third metal layers, facing each other and being insulated form each other; (c) disposing an optical device between the first and second electrodes; and (d) electrically connecting the optical device with the first electrode by means of a first wire and electrically connecting the optical device with the second electrode by means of a second wire.

### Advantageous Effects

The present invention is advantageous in that the heat emitted from an optical device can be efficiently discharged to the outside using a metal substrate.

Further, the present invention is advantageous in that the thickness of an anodized layer of a metal substrate can be easily adjusted.

Furthermore, the present invention is advantageous in that light use efficiency can be improved by forming a reflecting recess on a metal substrate, and in that an optical device can be easily aligned.

### Description of Drawings

FIG. 1 is a plan view showing a light emitting diode package array according to a first embodiment of the present invention.
FIG. 2 is a cross-sectional view of the light emitting diode package cut along the line I-I' in FIG. 1.
FIGS. 3 to 13 are cross-sectional views sequentially showing a method of manufacturing the light emitting diode package shown in FIG. 2.
FIG. 14 is a cross-sectional view showing a light emitting diode package according to a second embodiment of the present invention.
FIGS. 15 to 20 are cross-sectional views sequentially showing a method of manufacturing the light emitting diode package shown in FIG. 14.
FIG. 21 is a cross-sectional view showing a light emitting diode package according to a third embodiment of the present invention.
FIG. 22 is a cross-sectional view showing a light emitting diode package according to a fourth embodiment of the present invention.
FIG. 23 is a plan view showing a backlight unit including the light emitting diode package according to the embodiment of the present invention.

### <Description of the elements in the drawings>

| | |
|---|---|
| 10: metal substrate | 20: first anodized layer |
| 30: second anodized layer | 40: first metal layer |
| 50: second metal layer | 60: third metal layer |
| 70: first electrode | 71: third electrode |
| 80: second electrode | 81: fourth electrode |
| 90: reflecting recess | 100: light emitting diode |
| 110: first wire | 120: second wire |
| 130: protection layer | 140: protection cap |
| 400: substrate for light emitting diode | |
| 500: light emitting diode package | |

### Best Mode

The objects, features and advantages of the present invention will be more clearly understood from the following detailed description of preferred embodiments taken in conjunction with the accompanying drawings. However, it should be understood that the present invention is not limited to specific embodiments, and that simple modifications, additions and substitutions of the present invention belong to the scope of the present invention. In the description of the present invention, when it is determined that the detailed description of the related art would obscure the gist of the present invention, the description thereof will be omitted.

The terms "first", "second" and the like are used to differentiate a certain component from other components, but the configuration of such components should not be construed to be limited by the terms.

The terms used in the present application are used to explain specific embodiments, and these do not limit the scope of the present invention. The expression of singular form includes the expression of plural form as long as it is not apparently different from the expression of the plural form in the context. In the present application, it should also be understood that the terms "include", "have" and the like designate the existence of features, figures, steps, operations, components, parts or combinations thereof described in the specification, not that these terms previously exclude the existence or addition of one or more different features, figures, steps, operations, components, parts or combinations thereof.

Prior to the detailed description of drawings, the classification of components in the specification is only carried out according to their respective major functions. That is, two or more components may be made into one component, or one component may be divided into two or more components depending on the specific function. Further, each component may perform a part of the functions of other components or all of the functions of other components in addition to its own major functions, and a part of major functions of each component or all of major functions of each component may be performed by other components.

Hereinafter, preferred embodiments of the present invention will be described in detail with reference to the accompanying drawings. Throughout the accompanying drawings, the same reference numerals are used to designate the same or similar components, and redundant descriptions thereof are omitted.

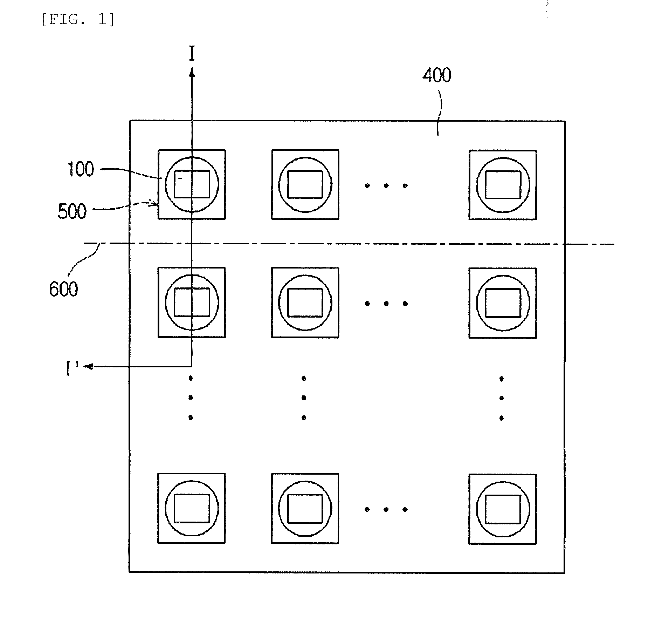

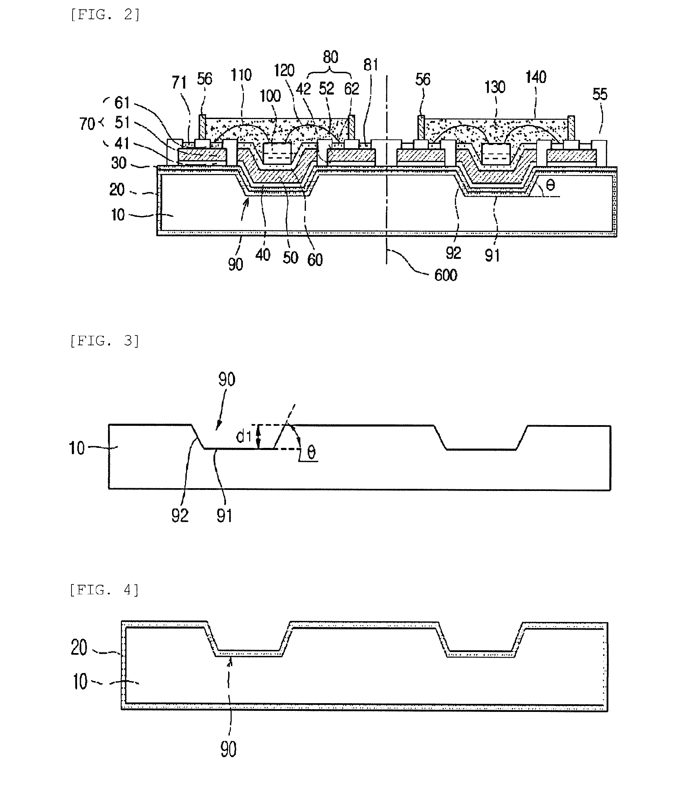

FIG. 1 is a plan view showing a light emitting diode package array according to a first embodiment of the present invention, and FIG. 2 is a cross-sectional view of the light emitting diode package cut along the line I-I' in FIG. 1. In the present invention, for the convenience of description, it is described that a substrate for a light emitting diode and a light emitting diode package are distinguished from each other, but a light emitting diode package may include a substrate for a light emitting diode.

Referring to FIGS. 1 and 2, the light emitting diode package according to the present invention may include a substrate 400 for a light emitting diode and a light emitting diode 100. Here, the substrate 400 for a light emitting diode may include a metal substrate 10, a reflecting recess 90, a first anodized layer 20, a second anodized layer 30, a photo solder resist pattern 55, first to fourth electrodes 70, 80, 71 and 81, and side walls 56. The substrate 400 for a light emitting diode may further include first and second wires 110 and 120 through which a voltage is applied to the light emitting diode 100. The substrate 400 for a light emitting diode may further include a protection layer 130 and a protection cap 140, each of which protects the light emitting diode 100.

In detail, the metal substrate 10 may be an aluminum substrate or an aluminum alloy substrate. The metal substrate 10, made of aluminum or an aluminum alloy, is advantageous in that it has high thermal conductivity and is easily processed. However, the metal substrate 10 may include titanium, magnesium, zinc, niobium or alloys thereof in addition to aluminum or aluminum alloy.

The reflecting recess 90 is formed in such a way that the metal substrate 10 is depressed. The reflecting recess 90 reflects the light emitted from the light emitting diode 100. Further, the reflecting recess 90 serves to help the light emitting diode 100 to be safely mounted on the metal substrate 10. The reflecting recess 90 includes a bottom surface 91 and an inclined reflecting surface 92.

The reflecting recess 90 may be formed such that the inclination angle (θ) made by the extended line of the bottom surface 91 and the reflecting surface 92 is 20 - 70°.

When the inclination angle is less than 20°, the reflecting surface 92 becomes larger, and thus the amount of light reflected from the reflecting surface 92 can increase, whereas the number of light emitting diodes 100 that can be disposed on the metal surface 10 having the same size can decrease. Further, when the inclination angle is more than 70°, the area of the reflecting surface 92 decreases, and thus the optical reflectance of the light emitting diode 100 can decrease.

The reflecting recess 90 may be formed to a depth (d1) of 200 ∼ 300 µm. However, the depth of the reflecting recess 90 may be changed depending on the shape of the light emitting diode 100 without being limited thereto. Further, the depth of the reflecting recess 90 may be changed depending on the thickness of the first and second anodized layers 20 and 30 formed in the reflecting recess 90.

The size of the reflecting recess 90 may be greatly changed depending on the number, size and shape of the light emitting diode 100. The reflecting recess 90, as shown in FIG. 1, is formed in the shape of a circle in order to increase the optical reflectance of the light emitting diode 100. However, the reflecting recess 90 may be formed in the shape of a polygon such as a triangle, a quadrangle or the like without being limited thereto.

The reflecting recess 90 can be used as a means for easily aligning a surface-emitting layer diode or a photodiode in addition to the light emitting diode 100 when the surface-emitting layer diode or the photodiode is safely mounted on the metal substrate 10. The reflecting recess 90 may be formed such that its shape is similar to the shape of an optical device, such as a light emitting diode or the like, mounted on the metal substrate 10.

The first anodized layer 20 is formed by anodizing the metal substrate 10. The first anodized layer 20 may be formed over the entire surface of the metal substrate 10. The first anodized layer 20 is formed such that voids do not exist in the first anodized layer 20 in order that the heat emitted from the light emitting diode 100 may be easily transferred to the metal substrate 10. The first anodized layer 20 insulates first to fourth electrodes 70, 80, 71 and 81 from the metal substrate 10. Further, the first anodized layer 20 insulates first to third metal layers 40, 50 and 60 from the metal substrate 10.

The first anodized layer 20 may include alumina (Al₂O₃) which is formed by the oxidization of aluminum. Since the first anodized layer 20 includes alumina, it has high thermal conductivity, and thus it can easily transfer the heat emitted from the light emitting diode 100 to the metal substrate 10.

The first anodized layer 20 may have a thickness of 0.2 ∼ 1.5 µm.

The second anodized layer 30 may be made of the same material as that of the first anodized layer 20, may include alumina formed by the anodizing process that is used to form the first anodized layer 20.

The second anodized layer 30 may be additionally formed when the first anodized layer 20 is thin.

In the embodiment of the present invention, a two-layered anodized layer is formed, but, if necessary, a three or more layered anodized layer may also be formed. Thus, the thickness of the anodized layer can be adjusted.

The first electrode 70 is formed on the second anodized layer 30. The first electrode 70 may be made of any one metal of chromium, copper, silver, aluminum, gold, tungsten, and the like. The first electrode 70 may be made of an alloy including any one metal of chromium, copper, silver, aluminum, gold, tungsten, and the like. Further, the first electrode 70 may be formed of a single layer or two or more layers. The first electrode 70, as shown in FIG. 2, may be formed by laminating first to third metal layers 41, 51 and 61.

That is, the first electrode 70 formed on the second anodized layer 30 may include a first metal layer 41 made of a chromium-containing metal material, a second metal layer 51 made of a copper-containing metal material and formed on the first metal layer 41, and a third metal layer 61 made of a silver-containing metal material and formed on the second metal layer 51.

Copper included in the second metal layer 51 has weak affinity for the second anodized layer 30. Therefore, the first metal layer 41, which is made of a chromium-containing metal material having strong affinity for the first electrode 70 and the second anodized layer 30, is formed between the second anodized layer 30 and the second metal layer 51.

The second metal layer 51 may be made of a metal material, such as copper, copper-nickel, copper-nickel-gold, or the like.

The third metal layer 61 is electrically connected with a first wire 110 by soldering or the like.

The second electrode 80 is made of the same metal as that of the first electrode 70. The second electrode 80, brought into contact with the second anodized layer 30, may include a first metal layer 42 made of chromium, a second metal layer 52 made of copper and formed on the first metal layer 42, and a third metal layer 62 made of silver and formed on the second metal layer 52.

The second metal layer 52 may be made of a conductive material such as copper, copper-nickel, copper-nickel-gold or the like.

The third metal layer 62 is made of a conductive material such as silver or the like. The third metal layer 62 is electrically connected with a second wire 120.

The third electrode 71 is formed by laminating the first to third metal layers 41, 51 and 61. Here, first and second metal layers of the third electrode 71 are respectively formed by extending the first and second metal layers 41 and 51 of the first electrode 70. The third electrode 71 may be made of silver or a silver-containing metal material. In this case, the third electrode 71 is electrically connected with a printed circuit board.

The fourth electrode 81 is formed by laminating the first to third metal layers 42, 52 and 62. Here, first and second metal layers of the fourth electrode 81 are respectively formed by extending the first and second metal layers 42 and 52 of the second electrode 80. The fourth electrode 81 may be made of silver or a silver-containing metal material. In this case, the fourth electrode 81 is electrically connected with a printed circuit board.

The first to fourth electrodes 70, 80, 71 and 81 of the present invention may be formed of only their respective first and second metal layers 41, 42, 51 and 52.

The photo solder resist pattern 55 is formed such that it covers the lateral sides of the first to fourth electrodes 70, 80, 71 and 81 to electrically insulate them. The photo solder resist pattern 55 may be formed over the entire region excluding the region in which the light emitting diode 100 is formed, as well as on the first and second electrodes 70 and 80. The photo solder resist pattern 55 may be made of a white material in order to reflect the light emitted from the light emitting diode 100.

The light emitting diode package according to the present invention may further include first to third metal layers 40, 50 and 60 formed on the region in which the light emitting diode 100 is formed, as well as on the first and second electrodes 70 and 80. The first to third metal layers 40, 50 and 60 formed on the region in which the light emitting diode 100 is formed serve to effectively transfer the heat emitted from the light emitting diode 100 to the metal substrate 10. Particularly, the third metal layer 60 is made of silver or a silver-containing metal material to increase optical reflectance.

The light emitting diode 100 is safely mounted in the reflecting recess 90, and the lower surface of the light emitting diode 100 is attached to the inner surface of the reflecting recess 90 by an adhesive or the like.

The light emitting diode 100 is electrically connected with the first electrode 70 by means of the first wire 110, and is electrically connected with the second electrode 80 by means of the second wire 120. The first and second wires 110 and 120 serve to supply the voltages produced from the first and second electrodes 70 and 80 to the light emitting diode 100.

The light emitting diode package 500 according to the present invention may further include a protection layer 130 and a protection cap 140, each of which protects the light emitting diode 100.

The protection layer 130 may be made of a mixture of phosphor and epoxy. The protection layer 130 can fix the light emitting diode 100. Here, the phosphor of the protection layer 130 can convert the light, having a predetermined color or wavelength, emitted from the light emitting diode 100 into white light and then discharge the white light to the outside. Conversely, the phosphor of the protection layer 130 can also convert the white light emitted from the light emitting diode 100 into light having a predetermined wavelength.

The protection cap 140 may be formed on the outer side of the protection layer 130, and may be made of a transparent material such as transparent plastic or the like.

The light emitting diode package 500 according to the present invention may further include side walls 56 for preventing the protection layer 130 from being detached outward.

The light emitting diode package 500 according to the present invention may further include a conductive metal layer made of nickel or a nickel-containing metal material on each of the second metal layers 61 and 62 of the first and second electrodes 70 and 80 in order to prevent the growth or oxidization of copper used to form the second metal layers 61 and 62.

In the present invention, the light emitting diode package mounted with a light emitting diode is described, but an optical device, such as a surface-emitting laser, a photodiode or the like may be used in addition to the light emitting diode.

FIGS. 3 to 13 are cross-sectional views sequentially showing a method of manufacturing a light emitting diode package according to the first embodiment of the present invention.

As shown in FIG. 3, reflecting recesses 90 are formed on a metal substrate 10 at regular intervals. Here, the metal substrate 10 may be made of any one of aluminum, titanium, magnesium, zinc, niobium and alloys thereof. Hereinafter, a metal substrate 10 made of aluminum or an aluminum alloy having a thermal expansion coefficient of 210 ∼ 230 W/m°K will be described as an example.

The reflecting recesses 90 are formed in order to improve the optical reflectance of the light emitted from a light emitting diode 100.

The reflecting recesses 90 may be formed by machining center (MCT) rapping. That is, the reflecting recesses 90 may be formed by machining the metal substrate 10 to a depth of several tens of micrometers to several hundreds of micrometers using MCT rapping which is a precise micromachining technology. The reflecting recesses 90 may also be formed by a metal machining process other than MCT rapping.

As shown in FIG. 3, each of the reflecting recesses 90 may include a bottom surface 91 and a reflecting surface 92 having an inclination angle (θ) from the bottom surface 91. Each of the reflecting recesses 90 may be formed such that the inclination angle (θ) made by the extended line of the bottom surface 91 and the reflecting surface 92 is 20 - 70°. Each of the reflecting recesses 90 may be formed such that the area of the open region thereof is larger than that of the bottom surface 91 thereof. Each of the reflecting recesses 90 may be formed such that its depth (d1) is 100 - 300 µm. However, the depth of each of the reflecting recesses 90 is not limited thereto.

The reflecting recesses 90 may be formed on the metal substrate 10 in a number of M x N (M and N are natural numbers).

Each of the reflecting recesses 90, as shown in FIG. 1, may be formed in the shape of a circle. However, each of the reflecting recesses 90 may be formed in the shape of a polygon such as a triangle, a quadrangle or the like without being limited thereto.

Subsequently, the surface of the metal substrate 10 provided with the reflecting recesses 90 is surface-treated by rapping, polishing, buffing or the like to make the surface thereof smooth. The surface treatment is pretreatment for forming uniform anodized layers.

Subsequently, as shown in FIG. 4, a first anodized layer 20 is formed on the metal substrate 10. The formation of the first anodized layer 20 is performed using a barrier type anodizing process in which a voltage is applied between the metal substrate 10 and an electrolyte with the metal substrate 10 immersed in an electrolyzer to form an alumina (Al₂O₃) layer on the surface of the metal substrate 10.

In this case, in the formation of the first anodized layer 20, a 100% alumina (Al₂O₃) layer is formed by removing voids from alumina (Al₂O₃) using borate or tartarate.

Concretely, the metal substrate 10 is immersed in an electrolyte such as neutral boric acid, ammonium borate, tartrate, ammonium tetraborate, ammonium tartrate or the like, and then a voltage of 250 - 450 V is applied between the metal substrate 10 and the electrolyte. In this case, when a high voltage is applied, the thickness of the first anodized layer 20 increases, and, when a low voltage is applied, the thickness of the first anodized layer 20 decreases. Therefore, the thickness of the first anodized layer 20 can be controlled by adjusting the voltage level.

In this case, the first anodized layer 20 may be formed to have a thickness of 0.2 - 1.5 µm.

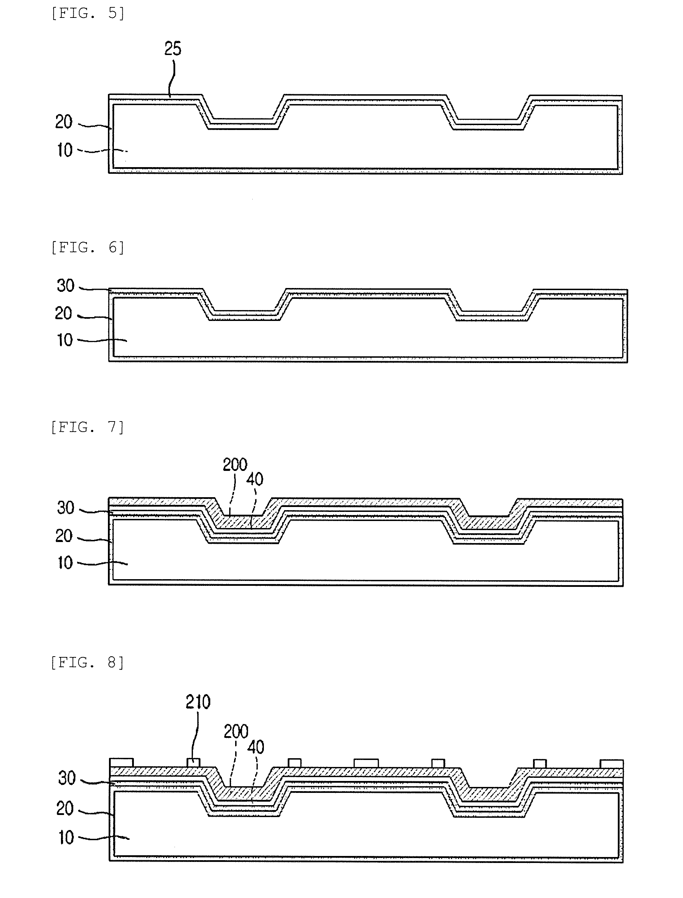

Subsequently, a metal layer 25 is formed on the first anodized layer 20. As shown in FIG. 5, the metal layer 25 is formed on the first anodized layer 20 using sputtering or chemical vapor deposition. The metal layer 25 may be formed to a thickness of 0.4 ∼ 1.5 µm.

The metal layer 25 may be made of any one of aluminum, titanium, magnesium, zinc, niobium and alloys thereof. In the present invention, a metal layer 25 made of aluminum or an aluminum alloy having a high thermal expansion coefficient and easily forming an anodized layer will be described as an example, but the present invention is not limited thereto.

Subsequently, as shown in FIG. 6, a second anodized layer 30 is formed by converting the metal layer 25 into an alumina layer using the barrier type anodizing process.

Here, the thickness of an anodized layer can be increased by repeatedly performing the step of forming the metal layer 25, shown in FIG. 5, and the step of converting the metal layer 25 into the second anodized layer 30, shown in FIG. 6. That is, a metal layer is formed on the second anodized layer 30, and then this metal layer is converted into another anodized layer using the barrier type anodizing process.

Subsequently, as shown in FIG. 7, a first metal layer 40 and a second metal layer 200 are sequentially formed on the second anodized layer 30 by sputtering or chemical vapor deposition. The first metal layer 40 may be made of chromium or a chromium alloy. The first metal layer 40 may also be made of a metal having strong affinity for the second anodized layer 30, other than chromium.

The second metal layer 200 may be made of copper or a copper alloy. The second metal layer 200 may also be made of a material having high conductivity, other than copper. Further, the second metal layer 200 may be made of a material which can be electrolytically copper-plated later.

Subsequently, as shown in FIG. 8, a photoresist pattern 210 is formed on the second metal layer 200. In the step of forming the photoresist pattern, the photoresist pattern 210 is formed on the second metal layer 200 by forming a photoresist on the second metal layer 200 and then exposing and developing the photoresist.

The photoresist pattern 210 is formed over the entire region excluding the region in which the reflecting recesses 90 were formed and the region in which first to fourth electrodes 70, 80, 71 and 81 will be formed.

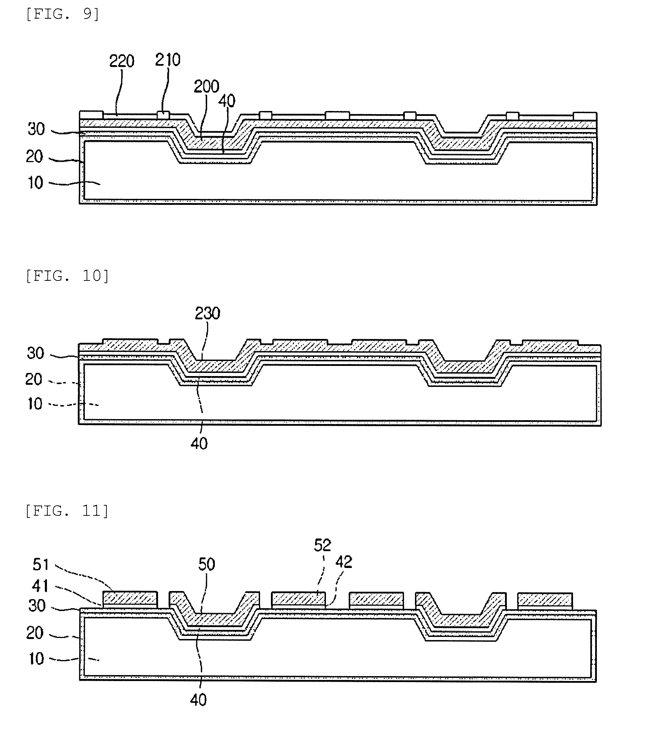

Subsequently, a metal pattern 220 is formed in the region exposed by the photoresist pattern 210. As shown in FIG. 9, the metal pattern 220 is formed in the region exposed by the photoresist pattern 210 using a metal that can be electrolytically plated, such as copper or a copper alloy. The metal pattern 220 may be formed by electrolytic-plating copper, copper-nickel, copper-nickel-gold or the like.

Subsequently, when the photoresist pattern 210 is removed, the second metal layer 200 is formed into an uneven metal layer 230, as shown in FIG. 10. The thin portion of the uneven metal layer 230 is removed by etching, and the thick portion of the uneven metal layer 230 remains. Subsequently, a part of the first metal layer 40 is removed by etching. That is, the first metal layer 40 exposed by the region in which the uneven metal layer 230 was removed is removed. Since the metal material constituting the uneven metal layer 230 is different from the metal material constituting the first metal layer 40, only the exposed region of the first metal layer 40 can be etched by a material that can etch only the first metal layer 40.

The pattern shown in FIG. 11 can be formed using the above etching process.

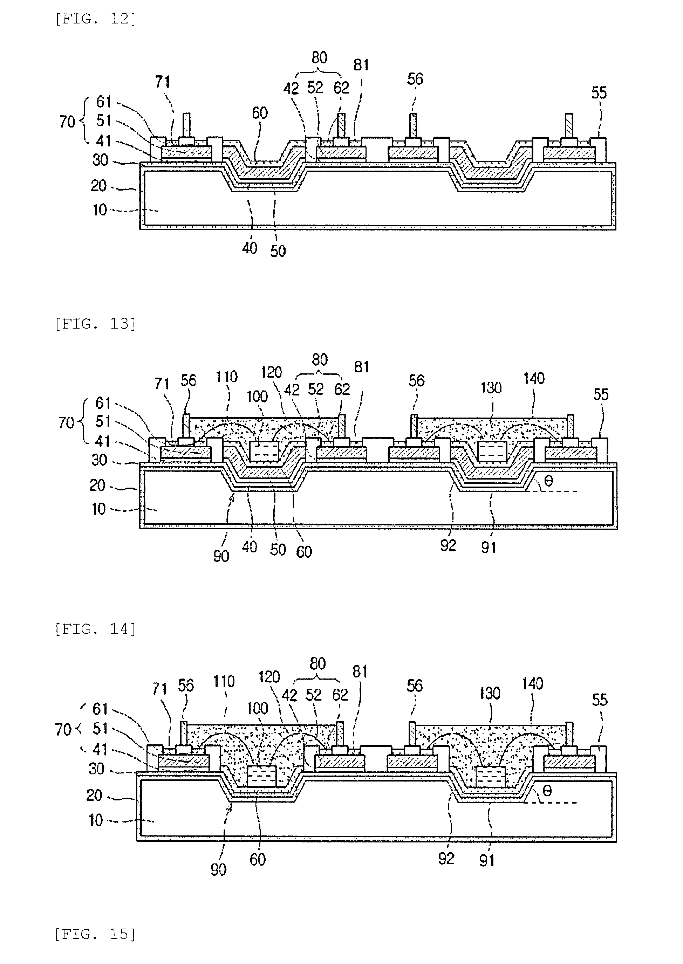

Subsequently, as shown in FIG. 12, a photo solder resist pattern 55 is formed. The photo solder resist pattern 55 is formed by forming a photo solder resist over the entire region and then exposing and developing the photo solder resist using a mask. In this case, the photo solder resist pattern 55 may be made of a white material in order to increase the reflectance of a light emitting diode.

Side walls 56 are formed after forming first to fourth electrodes 70, 80, 71 and 81 and metal layers in a region in which an optical device will be mounted. As shown in FIG. 12, the side walls 56 are formed between first and third electrodes 70 and 71 and between second and fourth electrodes 80 and 81 on the photo solder resist pattern 55. The side walls 56 may be made of a material having high reflectance. Further, the side walls 56 may be formed of the same material as that of the photo solder resist at the same time as the photo solder resist is formed.

Subsequently, third metal layers 60, 61 and 62 are formed on the region exposed by the photo solder resist pattern 55. The third metal layers 60, 61 and 62 may be made of a conductive metal. Particularly, the third metal layers 60, 61 and 62 formed on the region in which a light emitting diode 100 will be mounted, that is, the region in which the reflecting recess 90 was formed, may be made of a highly conductive metal. For example, the third metal layers 60, 61 and 62 may be made of silver or a silver-containing metal material, and may be formed by electroless plating, sputtering or the like.

Here, before the formation of the third metal layers 60, 61 and 62, a metal layer for preventing the growth of copper may further be formed using a metal, such as nickel or the like, when the second metal layer 230 is made of copper.

Subsequently, as shown in FIG. 13, a light emitting diode 100 is mounted on the third metal layer 60, and then first and second electrodes 70 and 80 are connected to the light emitting diode 100 by means of first and second wires 110 and 120, respectively. Thereafter, a protection layer 130 is formed, and is then covered with a protection cap 140.

Finally, the substrate 400 mounted with the light emitting diode 100 is cut along the line 600 to form a light emitting diode package. In this case, the substrate 400 may be cut and then mounted with the light emitting diode 100.

FIG. 14 is a cross-sectional view showing a light emitting diode package according to a second embodiment of the present invention. The light emitting diode package shown in FIG. 14 includes the same components as those of the light emitting diode package shown in FIG. 2, except that the first and second metal layers 40 and 50 of the light emitting diode package shown in FIG. 2 are removed. Hereinafter, description of the components overlapping with those of FIG. 2 will be omitted.

Referring to FIG. 14, the light emitting diode package according to the second embodiment of the present invention includes a substrate 400 for a light emitting diode, a light emitting diode 100, a first wire 110, and a second wire 120. Here, the substrate 400 for a light emitting diode may include a metal substrate 10, a reflecting recess 90, a first anodized layer 20, a second anodized layer 30, a photo solder resist pattern 55, first to fourth electrodes 70, 80, 71 and 81, and side walls 56.

Concretely, the metal substrate 10 may be made of aluminum, titanium, magnesium, zinc, niobium or an alloy thereof.

At least one reflecting recess 90 may be formed on one side of the metal substrate 10. The reflecting recess 90 is formed in such a way that the metal substrate 10 is depressed. The reflecting recess 90 may be formed in the shape of a circle. However, the reflecting recess 90 may be formed in the shape of a polygon such as a triangle, a quadrangle or the like without being limited thereto.

The reflecting recess 90 may be formed such that the inclination angle (θ) made by the extended line of the bottom surface 91 and the reflecting surface 92 is 20 - 70°. When the inclination angle is less than 20°, the reflecting surface 92 becomes larger, and thus the amount of light reflected from the reflecting surface 92 can increase, whereas the number of light emitting diodes 100 that can be disposed on the metal surface 10 having the same size can decrease. Further, when the inclination angle is more than 70°, the area of the reflecting surface 92 decreases, and thus the optical reflectance of the light emitting diode 100 can decrease.

The reflecting recess 90 may be formed to a depth (d1) of 200 ∼ 300 µm. However, the depth of the reflecting recess 90 may be changed depending on the shape of the light emitting diode 100 without being limited thereto. Further, the depth of the reflecting recess 90 may be changed depending on the thickness of the first and second anodized layers 20 and 30 formed in the reflecting recess 90.

The first anodized layer 20 is formed by anodizing the metal substrate 10. The first anodized layer 20 may be formed over the entire surface of the metal substrate 10. The first anodized layer 20 is formed such that voids do not exist in the first anodized layer 20 in order to increase the thermal conductivity thereof to the metal substrate 10. The first anodized layer 20 insulates first to fourth electrodes 70, 80, 71 and 81 from the metal substrate 10. The first anodized layer 20 may have a thickness of 0.2 - 1.5 µm.

The second anodized layer 30 is formed on the first anodized layer 20. The second anodized layer may be made of alumina (Al₂O₃) which is the same material as the first anodized layer 20. The second anodized layer 30 may have a thickness of 0.4 - 1.5 µm.

In the embodiment of the present invention, the formation of the first and second anodized layers 20 and 30 is described as an example, but another anodized layer may further be formed on the second anodized layer 30. Thus, the thickness of an anodized layer insulating the metal substrate 10 can be adjusted.

The photo solder resist pattern 55 electrically insulates a first electrode 70 and a second electrode 80. Further, the photo solder resist pattern 55, although not shown, may be formed over the entire region excluding the region in which the light emitting diode 100 is mounted and the region in which the first to fourth electrodes 70, 80, 71 and 81 are exposed outward.

The first electrode 70 may be formed by laminating first to third metal layers 41, 51 and 61. The first metal layer 41 may be made of chromium or a chromium-containing metal material, which has strong affinity for the second anodized layer 30. The second metal layer 51 may be made of copper or a copper-containing metal material, which has excellent electrical conductivity. The third metal layer 61 may be made of silver or a silver-containing metal material, which can be electroless-plated. The third metal layer 61 is exposed outward, and is electrically connected with the first wire 110.

The second electrode 80 may be formed by laminating first to third metal layers 42, 52 and 62. The first metal layer 42 may be made of chromium or a chromium-containing metal material, which has strong affinity for the second anodized layer 30. The second metal layer 52 may be made of copper or a copper-containing metal material, which has excellent electrical conductivity. The third metal layer 62 may be made of silver or a silver-containing metal material, which can be electroless-plated. The third metal layer 62 is exposed outward, and is electrically connected with the second wire 120.

The third electrode 71 is formed on the region in which the first and second layers 41 and 51 of the first electrode 70 are extended. The third electrode 71 is made of the same material as the third layer 61 of the first electrode 70 by the same process. In this case, the third electrode 71 may be connected with a printed circuit board (not shown). Therefore, the third electrode 71 can apply the voltage applied through a printed circuit board to the first electrode 70.

The fourth electrode 81 is formed on the region in which the first and second layers 42 and 52 of the second electrode 80 are extended. The fourth electrode 81 is made of the same material as the third layer 62 of the second electrode 80 by the same process. In this case, the fourth electrode 81 may be connected with a printed circuit board (not shown). Therefore, the fourth electrode 81 can apply the voltage applied through a printed circuit board to the second electrode 80.

The light emitting diode 100 is mounted on the region in which the reflecting recess 90 is formed. In this case, the light emitting diode 100 may be formed on the third metal layer 60. The third metal layer 60, although not described above, is made of a conductive material having high optical reflectance, such as silver or the like.

The first wire 110 drawn out from the light emitting diode 100 is electrically connected with the first electrode 70, and the second wire 120 drawn out from the light emitting diode 100 is electrically connected with the second electrode 80.

The light emitting diode package 500 according to this embodiment may further include a protection layer 130 for protecting the light emitting diode 100 from external factors. The protection layer 130 is made of a mixture of phosphor and epoxy. Since the protection layer 130 includes phosphor, it can convert the light, having a predetermined color, emitted from the light emitting diode 100 into white light. Further, the phosphor included in the protection layer 130 can also convert the white light emitted from the light emitting diode 100 into any one of red light, green light and blue light and discharge it to the outside.

The light emitting diode package according to this embodiment may further include a protection cap 140 formed on the outer side of the protection layer 130 and made of a transparent material such as transparent plastic or the like.

Meanwhile, the light emitting diode package according to the present invention may further include side walls 56 for preventing the protection layer 130 from being detached outward at the time of forming the protection layer 130. As shown in FIG. 14, each of the side walls may be formed such that the shape of the section thereof is a quadrangle. However, the shape of the section thereof is not limited thereto, and, in order to improve optical reflectance, may be a triangle or a trapezoid.

FIGS. 15 to 20 are cross-sectional views sequentially showing a method of manufacturing the light emitting diode package according to the second embodiment of the present invention, shown in FIG. 14.

The steps of forming reflecting recesses 90, a first anodized layer 20, a second anodized 30, a first metal layer 40 and a second metal layer 200 are the same as the steps of forming the same, shown in FIGS. 3 to 7, in the method of manufacturing a light emitting diode package according to the first embodiment of the present invention. Hereinafter, the steps after the step of forming the second metal layer 200 will be described.

First, reflecting recesses 90 are formed on a metal substrate 10. Subsequently, the surface of the metal substrate 10 provided with the reflecting recesses 90 is surface-treated by rapping, polishing, buffing or the like to make the surface thereof smooth. Subsequently, the surface of the metal substrate 10 is oxidized by a barrier type anodizing process to form a first anodized layer 20.

Subsequently, an aluminum layer is formed on the first anodized layer 20, and then the aluminum layer is oxidized by a barrier type anodizing process to form a second anodized layer 30.

Subsequently, a first metal layer 40 made of chromium or a chromium-containing metal material and a second metal layer 200 made of copper or a copper-containing metal material are sequentially formed on the second anodized layer 30 using sputtering, chemical vapor deposition or the like.

Subsequently, a photoresist pattern 210 is formed on the second metal layer 200. The photoresist pattern 210, shown in FIG. 15, is formed on the second metal layer 200 by applying a photoresist onto the second metal layer 200 and then exposing and developing the photoresist. In this case, the photoresist pattern 210 is formed on the entire region excluding the region in which first to fourth electrodes 70, 80, 71 and 81 will be formed.

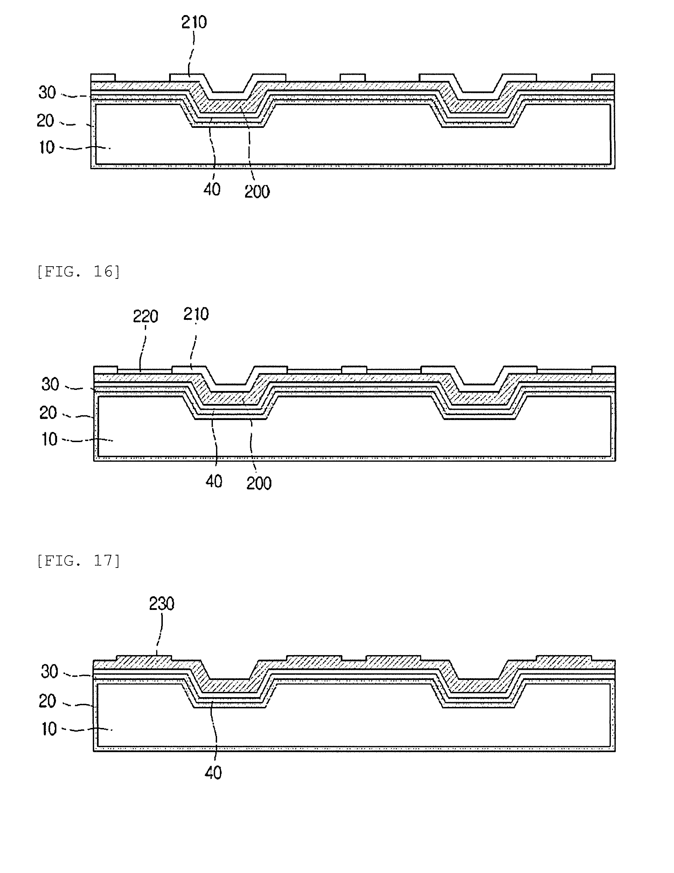

Subsequently, a metal pattern 220 is formed on the second metal layer 200 exposed by the photoresist pattern 210. As shown in FIG. 16, the metal pattern 220 is formed of the same material as the second metal layer 200 by electroless plating.

Subsequently, when the photoresist pattern 210 is removed, the second metal layer 200 is formed into an uneven metal layer 230, as shown in FIG. 17.

Subsequently, the thin portion of the uneven metal layer 230 is removed by wet etching or dry etching. When removing the uneven metal layer 230, the entire region of the uneven metal layer 230, excluding the region in which first to fourth electrodes 70, 80, 71 and 81 will be formed, is removed. Subsequently, the first metal layer 40 exposed by the removal of the uneven metal layer 230 is etched.

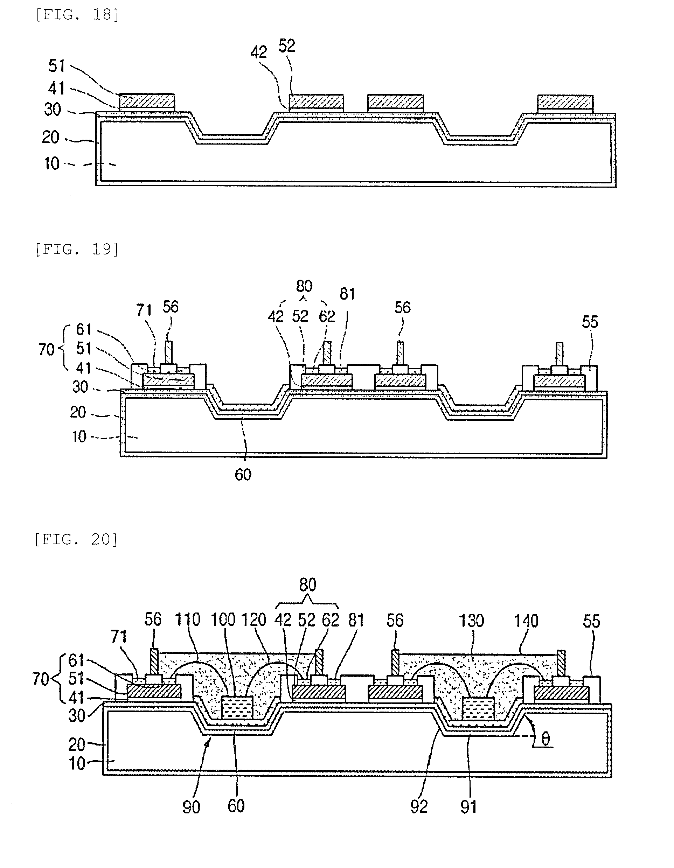

Subsequently, as shown in FIG. 19, a photo solder resist pattern 55 is formed. After the formation of the photo solder resist pattern 55, third metal layers 61 and 62 are formed of silver or a silver-containing metal material. Then, side walls 56 are formed. Here, the side wall 56 may be formed before the third metal layers 61 and 62 are formed.

Subsequently, as shown in FIG. 20, a light emitting diode 100 is mounted, and then first and second electrodes 70 and 80 are connected to the light emitting diode 100 by means of first and second wires 110 and 120, respectively. Subsequently, a protection layer 130 and a protection cap 140 are formed.

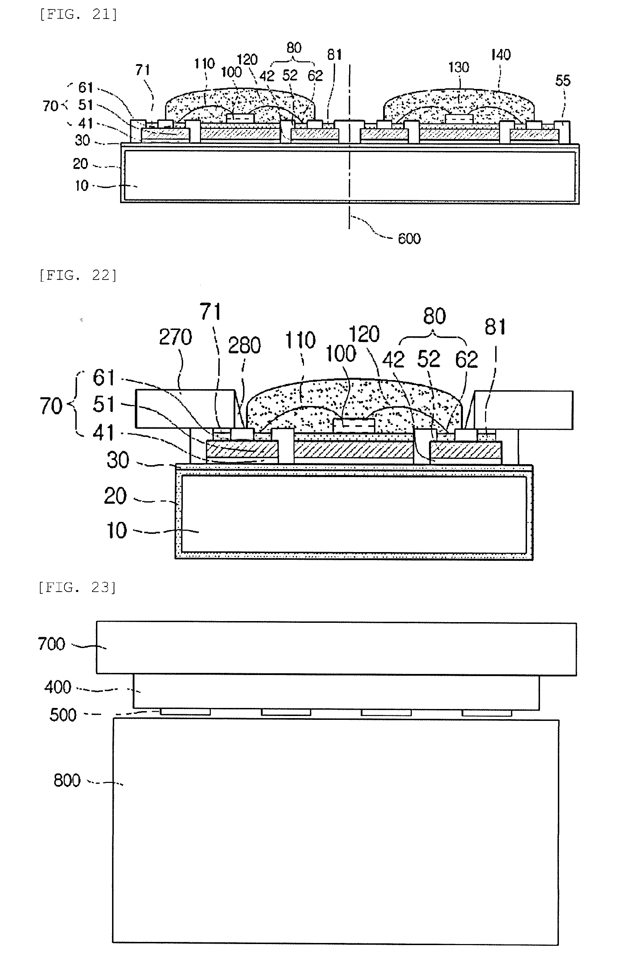

FIG. 21 is a cross-sectional view showing a light emitting diode package according to a third embodiment of the present invention. The light emitting diode package shown in FIG. 21 includes the same components as those of the light emitting diode package shown in FIG. 2, except that the reflecting recesses 90 of the light emitting diode package shown in FIG. 2 are not formed.

Concretely, the light emitting diode package according to the third embodiment of the present invention includes a substrate 400 for a light emitting diode, a light emitting diode 100. Here, the substrate 400 for a light emitting diode may include a metal substrate 10, and a first anodized layer 20 formed on the metal substrate 10. Further, the substrate 400 for a light emitting diode may further include a second anodized layer 30 formed on the first anodized layer 20.

The substrate 400 for a light emitting diode may include first to fourth electrodes 70, 80, 71 and 81. Since these first to fourth electrodes 70, 80, 71 and 81 are the same as those shown in FIG. 2, description thereof will be omitted.

A light emitting diode 100 is mounted on a third metal layer 60, and a first wire 110 is connected with a first electrode by soldering or the like.

A protection layer 130 is made of a mixture of phosphor and epoxy to cover the light emitting diode 100. A protection cap is formed on the protection layer 130.

Meanwhile, in the light emitting diode package according to the third embodiment of the present invention, first and second metal layers 40 and 50 may be removed from the region in which the light emitting diode is mounted. Further, the light emitting diode package according to the third embodiment of the present invention may further include the side walls 56 shown in FIG. 2.

The method of manufacturing the light emitting diode package according to the third embodiment of the present invention is the same as the method of manufacturing the light emitting diode package according to the first embodiment of the present invention, except that the step of forming reflecting recesses is not conducted.

FIG. 22 is a cross-sectional view showing a light emitting diode package according to a fourth embodiment of the present invention. The light emitting diode package shown in FIG. 22 includes the same components as those of the light emitting diode package shown in FIG. 2, except that a printed circuit board 270 is attached to the light emitting diode package shown in FIG. 2, and a reflecting plate 280 is provided between the printed circuit board 270 and a protection cap 140. Hereinafter, description of the components overlapping with those of FIG. 2 will be omitted.

The reflecting plate 280 may be made of a metallic or nonmetallic material having high reflectance. The reflecting plate 280 may further include a reflective film formed by coating a nonmetallic material with a material having high reflectance.

The light emitting diode of the present invention can be used for a backlight unit of a liquid crystal display.

FIG. 23 is a plan view showing a backlight unit using the light emitting diode package according to the embodiment of the present invention.

Referring to FIG. 23, the backlight unit includes a light guide panel 800, a light emitting diode package 500, and a frame.

The light emitting diode 500 may be a bar type light emitting diode.

The light guide panel 800 guides the light emitted from a light emitting diode 100 and discharges this light uniformly in a vertical direction.

The frame 700 is attached to one side of the light emitting diode 500.

In the backlight unit, the heat emitted from the light emitting diode 100 is transferred to a substrate 400 for a light emitting diode, and is then discharged to the outside through the frame 700 connected to the substrate 400. Therefore, even when a large number of light emitting diodes 100 are used, the heat emitted therefrom is easily discharged to the outside.

In FIG. 23, an edge type backlight unit is shown, but a surface illuminant type backlight unit may be used.

Further, the substrate for an optical device, optical device package, and manufacturing method thereof may be used for indoor and outdoor illuminating apparatuses.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

### Industrial Applicability

The present invention is advantageous in that the heat emitted from an optical device can be efficiently discharged to the outside using a metal substrate.

Further, the present invention is advantageous in that the thickness of an anodized layer of a metal substrate can be easily adjusted.

Furthermore, the present invention is advantageous in that light use efficiency can be improved by forming a reflecting recess on a metal substrate, and in that an optical device can be easily aligned.

## Claims

1. A substrate for an optical device, comprising:
a metal substrate;
a first anodized layer formed on the metal substrate to insulate the metal substrate; and
first and second electrodes formed on the first anodized layer such that the first and second electrodes are insulated from each other.

2. The substrate for an optical device according to claim 1, further comprising: a second anodized layer formed on the first anodized layer.

3. The substrate for an optical device according to claim 1, further comprising: a first metal layer made of chromium or a chromium alloy; and a second metal layer formed on the first metal layer and made of copper or a copper-containing metal material.

4. The substrate for an optical device according to any one of claims 1 to 3, further comprising: a reflecting recess provided between the first and second electrodes and formed by pressing the metal substrate.

5. The substrate for an optical device according to claim 4, further comprising: a third metal layer formed on the reflecting recess and made of silver or a silver-containing metal material.

6. An optical device package, comprising:
a substrate for an optical device including a metal substrate, a first anodized layer formed on the metal substrate and insulating the metal substrate, and a substrate for an optical device including first and second electrodes formed on the first anodized layer and insulated from each other;
an optical device disposed between the first and second electrodes;
a first wire connecting the optical device with the first electrode; and
a second wire connecting the optical device with the second electrode.

7. The optical device package according to claim 6, further comprising: a second anodized layer formed on the first anodized layer.

8. The optical device package according to claim 6, further comprising: at least one of a first metal layer made of chromium or a chromium alloy; a second metal layer made of copper or a copper-containing conductive material; and a third metal layer made of silver or a silver-containing conductive material.

9. The optical device package according to claim 6, further comprising: a third metal layer, provided beneath the optical device, insulated from the first and second electrodes and made of silver or a silver-containing metal material.

10. The optical device package according to any one of claims 6 to 9, wherein the metal substrate comprises a reflecting recess provided with the optical device and formed by pressing the metal substrate.

11. The optical device package according to claim 10, further comprising:
a protection layer covering the optical device; and
a protection cap formed on the protection layer,
wherein the protection layer includes phosphor for converting light emitted from the optical device into white light.

12. The optical device package according to claim 11, further comprising: side walls for preventing the protection layer from being detached outward.

13. A method of manufacturing a substrate for an optical device, comprising the steps of:
(a) forming a first anodized layer on a surface of a metal substrate to insulate the metal substrate;
(b) forming a second anodized layer on the first anodized layer;
(c) forming a first metal layer on the first anodized layer;
(d) forming a second metal layer on the first metal layer; and
(e) etching the first metal layer and the second metal layer to form first and second electrodes that face each other and are insulated from each other.

14. The method of manufacturing a substrate for an optical device according to claim 13, wherein, in the step (a), the first anodized layer is formed on the surface of the metal substrate by anodizing the metal substrate using borate or tartarate.

15. The method of manufacturing a substrate for an optical device according to claim 13, wherein the step (b) comprises the steps of:
forming a metal layer on the first anodized layer; and
anodizing the metal layer using borate or tartarate.

16. The method of manufacturing a substrate for an optical device according to claim 13, wherein the steps (c) and (d) comprises the steps of:
sequentially depositing the first and second metal layers;
forming a photoresist pattern on the second metal layer, the photoresist pattern being formed by removing a photoresist from a region in which the first and second electrodes will be formed;
plating the second metal layer exposed by the photoresist pattern with the same material as the second metal material, and then removing the photoresist pattern to form an uneven second metal layer;
removing the thin portion of the uneven second metal layer excluding the thick portion thereof by a first etching process to expose the first metal layer; and
removing the exposed portion of the first metal layer by a second etching process.

17. The method of manufacturing a substrate for an optical device according to claim 13, further comprising the step of: forming a reflecting recess between the first and second electrodes by pressing the metal substrate before the step (a).

18. The method of manufacturing a substrate for an optical device according to claim 17, further comprising the step of: forming a third metal layer made of silver or a silver-containing metal material on the second anodized layer or the second metal layer in the region in which the reflecting recess is formed.

19. A method of manufacturing an optical device package, comprising the steps of:
(a) forming a first anodized layer on a surface of a metal substrate to insulate the metal substrate;
(b) forming first and second electrodes on the first anodized layer, the first and second electrodes including any one of first, second and third metal layers, facing each other and being insulated form each other;
(c) disposing an optical device between the first and second electrodes; and
(d) electrically connecting the optical device with the first electrode by means of a first wire and electrically connecting the optical device with the second electrode by means of a second wire.

20. The method of manufacturing an optical device package according to claim 19, further comprising the step of: forming a second anodized layer on the first anodized layer after the step (a),
wherein the step of forming the second anodized layer comprises the steps of:
applying a metal material onto the first anodized layer; and
anodizing the metal material using borate or tartarate.

21. The method of manufacturing an optical device package according to claim 19, wherein the step (b) comprises the step of:
forming at least one of metal layers the same as the first, second and third metal layers on the region in which the optical device will be disposed.

22. The method of manufacturing an optical device package according to any one of claims 19 to 21, further comprising the step of: forming a reflecting recess on the region, in which the optical device will be disposed, by pressing the metal substrate before the step (a).
